# FASCICULE DE BREVET EUROPEEN

(11) **EP 3 462 824 B1**
(45) Date de publication et mention de la délivrance du brevet: **22.07.2020**
(21) Numéro de dépôt: 18197068.2
(22) Date de dépôt: 27.09.2018
(51) Int. Cl.: H05K 7/20

(54) **ONDULEUR COMPACT ET VÉHICULE AUTOMOBILE COMPRENANT UN TEL ONDULEUR**
KOMPAKTER WECHSELRICHTER UND KRAFTFAHRZEUG, DAS EINEN SOLCHEN WECHSELRICHTER ENTHÄLT
COMPACT INVERTER AND MOTOR VEHICLE COMPRISING SUCH AN INVERTER

(30) Priorité: 28.09.2017 FR 1759031
(43) Date de publication de la demande: 03.04.2019
(73) Titulaire: Aciltek, 75116 Paris (FR)
(72) Inventeur: SAINSAULIEU, Lionel, 75116 PARIS (FR); FAVRE, Jacques, 31400 Toulouse (FR); RIZET, Corentin, 73460 MONTAILLEUR (FR); IBRAHIM, Mahmoud, 38400 SAINT MARTIN D'HERES (FR)
(74) Mandataire: Lavoix

(56) Documents cités:
- EP-A1- 2 323 469
- EP-A1- 2 741 412
- EP-A2- 1 956 649
- EP-A2- 2 101 402

## Description

La présente invention concerne un onduleur destiné à alimenter une charge électrique en courant triphasé, à partir d'un courant continu.

Le domaine de l'invention est, plus particulièrement, celui des véhicules hybrides ou électriques dans lesquels l'énergie est stockée dans une batterie d'accumulateurs afin d'alimenter un moteur de traction fonctionnant en courant alternatif.

Pour ce genre d'application, il est nécessaire de transformer le courant continu sortant de la batterie d'accumulateurs en courant alternatif triphasé, ce pour quoi on utilise un onduleur. De façon générale, un tel onduleur comprend une cellule de commutation qui inclut des circuits d'alimentation à découpage, cette cellule de commutation étant commandée par un circuit de commande. Classiquement, la cellule de commutation comprend trois demi-ponts en H, chaque demi-pont étant composé de deux interrupteurs. Les cellules de commutation sont relativement volumineuses et équipées de radiateurs de refroidissement sur un seul côté. Ces cellules de commutation ont donc tendance à rayonner de la chaleur sur leur côté dépourvu de radiateur, en direction de la ou des cartes électroniques de commande. Comme le refroidissement des composants électroniques de la cellule de commutation est relativement limité, les dimensions de ces composants doivent être augmentées, en partant de l'hypothèse que plus leur surface est importante, plus la surface de contact avec le radiateur est importante et meilleure est l'évacuation de la chaleur. Ceci tend à augmenter les dimensions d'une cellule de commutation, donc les dimensions d'un onduleur qui comprend une telle cellule. D'autres cellules de commutation proposent un refroidissement double face mais ce dernier est souvent non optimal et de nouveau, les dimensions des composants doivent être augmentées afin d'augmenter la surface de contact avec le radiateur.

D'autre part, un onduleur comprend généralement un filtre capacitif comprenant un ou plusieurs condensateurs disposés en parallèle de la cellule de commutation, entre les bornes d'entrée de l'onduleur, afin de filtrer les oscillations de tension. Le ou les condensateurs d'un tel filtre capacitif sont dimensionnés en tenant plus particulièrement compte de la valeur efficace ou valeur RMS, pour « Root Mean Square » en Anglais, des courants de phase en sortie de l'onduleur. Par exemple, pour un onduleur qui commute des courants de phase de 500 ampères (A) RMS, le condensateur doit pouvoir laisser passer des courants de 65% de cette valeur soit 325 A RMS. Il en résulte que les condensateurs du filtre capacitif sont volumineux.

Pour toutes ces raisons, un onduleur qui permet de commuter des courants de phase de 500 A RMS occupe généralement un volume compris entre 6 et 8 litres.

Or, la place est comptée dans un véhicule automobile, tout particulièrement dans le compartiment moteur d'un véhicule hybride.

Par ailleurs, il est connu dans la littérature, notamment de l'article de LYU et al. intitulé « DC - Link RMS Current Reduction by Increasing Parallel Three-Phase Inverter Module Number for Segmented Traction drive » dans IEEE JOURNAL OF EMERGING AND SELECTED TOPICS IN POWER ELECTRONICS, volume 5, number 1, March 2017, de réaliser la cellule de commutation d'un onduleur en entrelaçant, pour chaque phase, deux ensembles d'interrupteurs commandés, branchés en parallèle entre les deux bornes d'entrée de l'onduleur et qui permettent de délivrer en parallèle deux courants alternatifs, sur chaque phase d'un moteur.

Par ailleurs, US-A-2006/0138993 divulgue un onduleur dont la cellule de commutation comprend des ensembles d'interrupteurs imbriqués qui permettent, soit d'alimenter deux moteurs en parallèle, soit d'alimenter un moteur avec possibilité de le faire tourner dans deux sens opposés. US-A-2006/0138993 ne se préoccupe pas de l'encombrement de l'onduleur.

Enfin, il est connu de EP-A-2010402 de réaliser un conduit de circulation de fluide caloporteur dans l'épaisseur d'un module semi-conducteur comprenant, entre autres, un condensateur, au sein d'un onduleur.

La présente invention vise à améliorer la compacité des onduleurs connus en proposant une nouvelle structure d'onduleur dans laquelle le dimensionnement des composants électriques est amélioré, grâce à la structure de la cellule de commutation, ce qui permet de diminuer le volume du filtre capacitif, et dans lequel le refroidissement des parties de l'onduleur qui ont tendance à s'échauffer est effectué de manière particulièrement efficace, ce qui permet de nouveau de diminuer le volume du filtre capacitif.

A cet effet, l'invention concerne un onduleur destiné à être raccordé électriquement à une source de tension continue pour alimenter une charge électrique en courant triphasé, cet onduleur comprenant une cellule de commutation qui inclut elle-même, pour chaque phase du courant, un circuit d'alimentation à découpage formé par deux ensembles d'interrupteurs commandés, chaque ensemble d'interrupteurs commandés alimentant une borne distincte de la cellule de commutation, alors que cette cellule de commutation comprend un boîtier étanche contenant les circuits d'alimentation à découpage. Cet onduleur comprend également un filtre capacitif. Conformément à l'invention, le boîtier est pourvu, sur deux faces opposées, de moyens d'échange thermique avec un fluide caloporteur. Un distributeur est monté, en amont du boîtier, dans un circuit de circulation de fluide caloporteur, pour diriger le fluide caloporteur vers les deux faces opposées du boîtier. En outre, le filtre capacitif est refroidi au moyen d'au moins un caloduc, alors qu'une partie de ce caloduc, où se produit la condensation d'un fluide contenu dans le caloduc, est en contact thermique avec le distributeur.

Grâce à l'invention, la structure de la cellule de commutation, avec deux ensembles imbriqués d'interrupteurs commandés pour chaque phase, limite la valeur efficace du courant de sortie de la cellule de commutation, ce qui permet d'utiliser, pour le filtre capacitif, un ou des condensateurs moins volumineux. Comme le boîtier de la cellule de commutation peut être refroidi sur ses deux faces opposées, grâce aux moyens d'échanges thermiques, le refroidissement de cette cellule de commutation est plus efficace et celle-ci n'a pas besoin de grandes surfaces de silicium pour dissiper la chaleur. L'utilisation d'un ou plusieurs caloducs permet un refroidissement particulièrement fiable et efficace du filtre capacitif, en tirant parti du fait que, en entrée de l'onduleur, le fluide caloporteur a une température relativement basse, qui permet de condenser efficacement le fluide contenu dans ce caloduc. Pour toutes ces raisons qui se combinent entre elles, l'onduleur de l'invention a un fonctionnement électrique et thermique optimisé, qui permet de l'inclure dans un volume sensiblement plus faible que les matériels connus, ce volume étant inférieur à trois litres, en pratique de l'ordre de deux litres, pour un onduleur délivrant des courants de phase continus de 600 A RMS.

Selon des aspects avantageux mais non obligatoires de l'invention, un tel onduleur peut incorporer une ou plusieurs des caractéristique suivantes, prises selon toute combinaison techniquement admissible :
- Le filtre capacitif est refroidi par plusieurs caloducs qui s'étendent en parallèle entre le filtre capacitif et le distributeur.
- La partie de chaque caloduc en contact thermique avec le distributeur est sa portion d'extrémité opposée au filtre capacitif.
- La partie de chaque caloduc en contact thermique avec le distributeur est collée ou soudée sur une surface externe du distributeur.
- La cellule de commutation est divisée en trois modules qui comprennent chacun deux bornes d'entrée, deux bornes de sortie, deux ensembles d'interrupteurs, montés en parallèle entre les deux bornes d'entrée et raccordés chacun à une borne de sortie et une partie du boîtier qui inclut les deux ensembles d'interrupteurs.
- Le boîtier définit un canal de circulation de fluide caloporteur sur chacune de ses faces opposées.
- Chaque partie du boîtier définit une partie de chacun des canaux de circulation de fluide caloporteur et ces parties de conduits sont alignées et en communication fluidique lorsque la cellule de commutation est constituée par l'assemblage des trois modules.
- Le filtre capacitif comprend au moins un condensateur relié à la cellule de commutation au moyen d'un busbar, au moins un caloduc est en contact thermique directement avec le filtre capacitif ou indirectement, c'est-à-dire en contact avec une plaque ou un élément du busbar , lui-même en contact avec le filtre capacitif et ce caloduc est également en contact avec le distributeur.
- Le filtre capacitif a une capacité supportant une tension d'alimentation entre 300 V et 950 V, la cellule de commutation est apte à alimenter chaque phase de la charge électrique avec deux courants électriques alternatifs dont l'intensité est comprise entre 100 et 500 A RMS, l'onduleur délivre des courants de phase cumulés de 600 A RMS et le volume total de l'onduleur est inférieur ou égal à 8 litres, de préférence à 6 litres, de préférence encore à 3 litres, de façon plus préférentielle à 2 litres.

Selon un autre aspect, l'invention concerne un véhicule automobile comprenant une batterie d'accumulateurs, un moteur électrique de traction et un onduleur d'alimentation de ce moteur de traction en courant triphasé, à partir d'un courant continu délivré par la batterie d'accumulateurs. Conformément à l'invention, l'onduleur est tel que mentionné ci-dessus.

Un tel véhicule automobile est plus facile à concevoir et sa maintenance est plus aisée, compte tenu du volume relativement faible de l'onduleur.

L'invention sera mieux comprise et d'autres avantages de celle-ci apparaîtront plus clairement à la lumière de la description qui va suivre, d'un mode de réalisation d'un onduleur et d'un véhicule automobile conformes à son principe, donnée uniquement à titre d'exemple et faite en référence aux dessins annexés, dans lesquels :
- la figure 1 est une représentation électrique schématique d'une partie d'un véhicule automobile conforme à l'invention, incorporant un onduleur conforme à l'invention ;
- la figure 2 est une vue en perspective, avec arrachement partiel, d'un module appartenant à une cellule de commutation de l'onduleur de la figure 1 ;
- la figure 3 est une vue partielle en perspective éclatée de l'onduleur de la figure 1 ;
- la figure 4 est une vue de côté de l'onduleur de la figure 1.

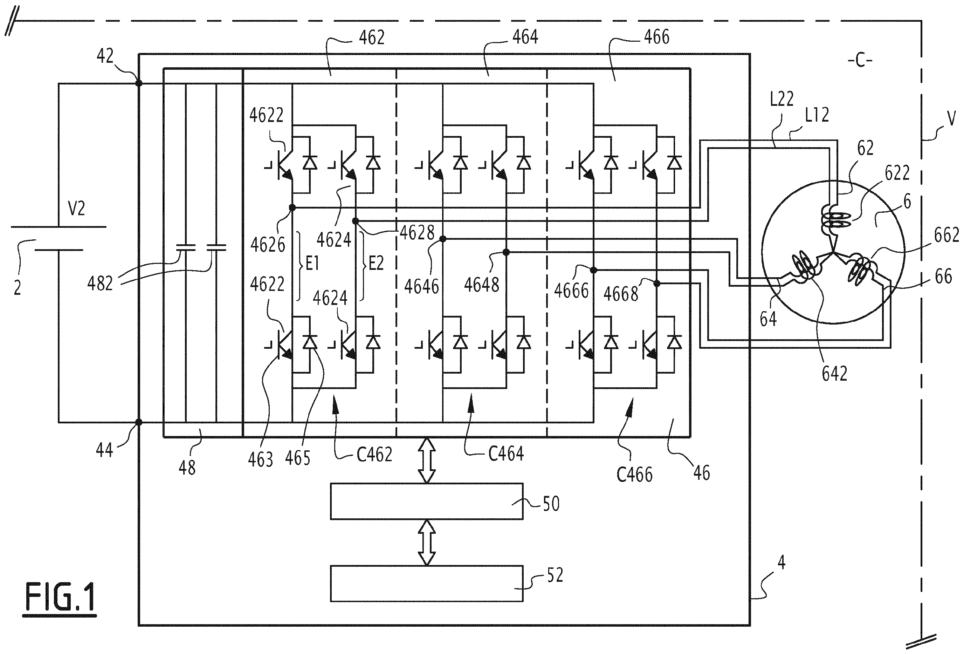

A la figure 1, la chaîne de traction électrique C d'un véhicule automobile hybride V est partiellement représenté. Cette chaîne de traction C inclut une batterie d'accumulateurs 2, un onduleur 4 et un moteur de traction triphasé 6.

La batterie d'accumulateurs 2 délivre une tension continue V2, comprise entre 300 et 950 V, par exemple égale à 450 V. La batterie 2 est branchée sur deux bornes d'entrée 42 et 44 de l'onduleur 4.

Cet onduleur 4 comprend une cellule de commutation 46 et un filtre capacitif 48, tous deux branchés en parallèle entre les bornes 42 et 44.

L'onduleur 4 comprend également une carte de commande 50 et une carte de contrôle 52. En pratique, ces cartes 50 et 52 peuvent être réunies sur une seule carte physique.

La cellule de commutation 46 est formée de trois modules identiques 462, 464 et 466 respectivement prévus pour alimenter la première phase 62, la deuxième phase 64 et la troisième phase 66 du moteur de traction 6. Sur la figure 1, les modules 462, 464 et 466 sont délimités entre eux par des traits pointillés verticaux.

Chaque module 462, 464 ou 466 comprend un circuit d'alimentation à découpage formé par deux ensembles d'interrupteurs disposés en parallèle entre les bornes 42 et 44. Par exemple, le module 462 comprend un premier circuit C462 formé d'un premier ensemble E1 de deux interrupteurs 4622 et d'un deuxième ensemble E2 de deux interrupteurs 4624. Tous les interrupteurs de la cellule de commutation 46 sont identiques et comprennent un transistor bipolaire à grille isolée 463 ou IGBT (de l'anglais « Insulated Gâte Bipolar Transistor »), ainsi qu'une diode de roue libre 465.

En variante non représentée, il est aussi possible de concevoir cette cellule de commutation à partir de composants MOS , pour « Métal Oxyde Semi-conducteur, ou de semi-conducteurs à grand gap, tels que le Carbure de Silicium (SiC) ou le Nitrure de Gallium (GaN). Dans ces cas, la diode de roue libre n'est pas nécessaire.

Une première borne de sortie 4626 du module 462 est raccordée électriquement entre les deux interrupteurs 4622 de l'ensemble E1. Une deuxième borne de sortie 4628 du module 462 est raccordée électriquement entre les interrupteurs 4624 de l'ensemble E2. Deux lignes électriques L12 et L22, avantageusement formées par des câbles conducteurs, relient respectivement les bornes 4626 et 4628 à un bobinage 622 de la première phase 62 du moteur de traction 6.

De la même façon, des premier et deuxième ensembles d'interrupteurs commandés, non référencés mais visibles à la figure 1, sont formés dans les modules 464 et 466 et leurs bornes de sortie respectives 4646, 4648, 4666 et 4668 sont respectivement alimentées par des circuits C464 et C466 et raccordées aux bobinages 642 et 662 des deuxième et troisième phases 64 et 66 du moteur 6.

Compte tenu du mode de branchement des interrupteurs 4622, 4624 et équivalents de la cellule de commutation 46, le courant de sortie transitant dans les lignes L12, L22 et équivalentes présente une intensité RMS égale à environ la moitié de l'intensité RMS qu'aurait un courant produit par des modules incluant un seul ensemble d'interrupteurs, pour le même moteur de traction 6.

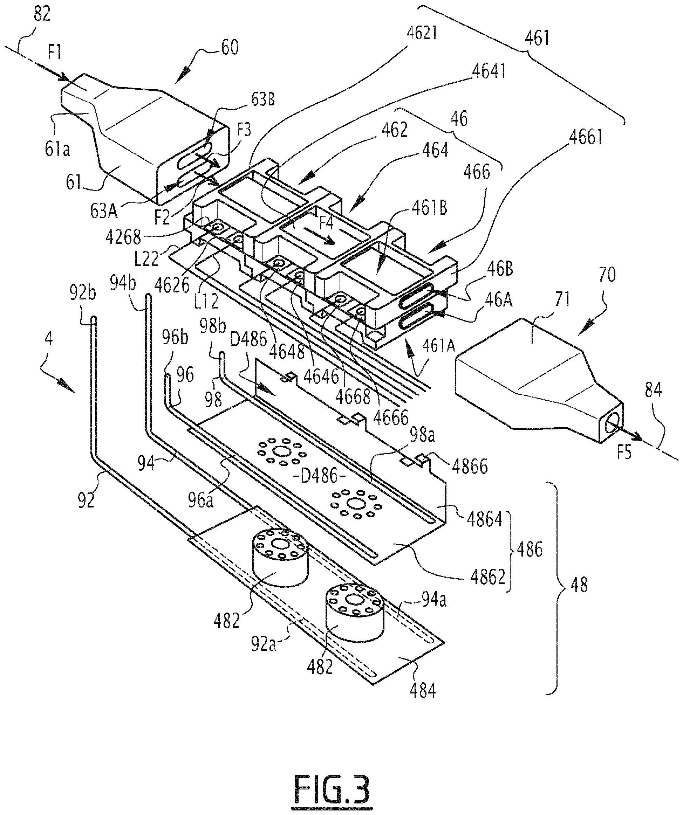

La carte de commande 50 permet de commuter les transistors 463 selon une séquence prédéterminée et la carte de contrôle 52 pilote l'ensemble. Pour la clarté du dessin, ces cartes 50 et 52 sont omises à la figure 3.

En prenant l'exemple d'un moteur de traction 6 devant être alimenté avec un courant de phase de 600 A RMS, les courants de phase transitant sur chacune sur des lignes L12, L22 et équivalentes ont une intensité de 300 A RMS.

Dans l'exemple des figures, l'onduleur peut être configuré pour que chaque borne 4226, 4628, 4646, 4648, 4666 et 4668 délivre un courant de phase dont l'intensité est comprise entre 100 et 500 A RMS.

L'onduleur 4 délivre, sur chaque phase du moteur de traction 6 un courant cumulé dont l'intensité est la somme des courants de phase issu des bornes 4226 et 4628 pour la phase 62, 4646 et 4648 pour la phase 64, et 4666 et 4668 pour la phase 66. Ainsi, l'onduleur 4 peut alimenter les phases du moteur de traction 6 avec des courants cumulés dont l'intensité est comprise entre 200 et 1000 A RMS.

Le filtre capacitif 48 comprend un ou plusieurs condensateurs 482. Dans l'exemple, deux condensateurs sont utilisés. A eux deux, et dans cet exemple, ces condensateurs voient passer un courant correspondant à environ 32% de la valeur RMS des courants de phase soit 192 A RMS.

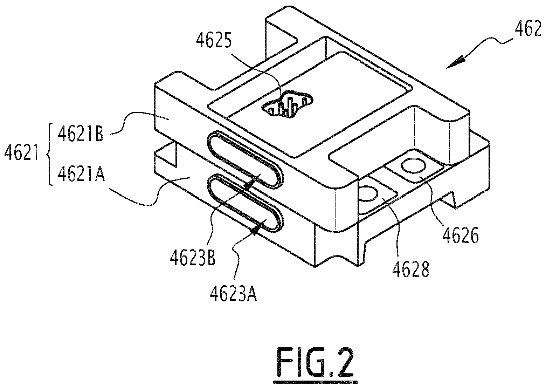

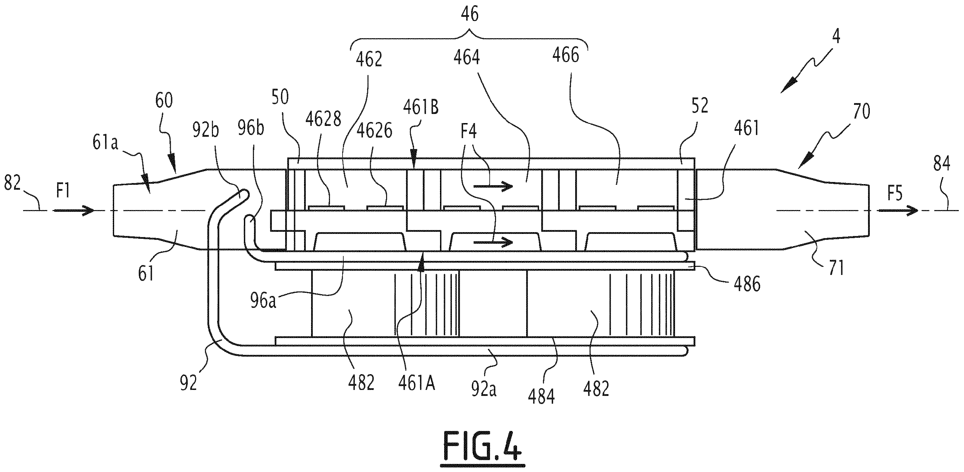

Le module 462 de la cellule de commutation 46 est représenté seul, en vue extérieure, à la figure 2 et, toujours en vue extérieure, au sein de la cellule de commutation 46 aux figures 3 et 4. Ce module comprend un boîtier unitaire étanche 4621 formé de deux demi-boîtiers 4621A et 4621B disposés de part et d'autre des plaques de circuit électronique qui supportent le circuit C462. Ces demi-boîtiers sont assemblés de façon étanche et laissent apparentes des bornes, non visibles, de connexion aux bornes d'entrée 42 et 44 de l'onduleur 4 et les bornes de sortie 4626 et 4628.

Le boîtier unitaire 4621 est réalisé dans un matériau électriquement isolant, par exemple en Ultem (marque déposée) Polyetheride (PEI).

Chacun des demi-boîtiers 4621A et 4621B définit un conduit 4623A, respectivement 4623B, permettant de faire circuler un fluide caloporteur, tel que de l'eau additivée, ou tout autre fluide caloporteur, au voisinage immédiat des interrupteurs 4622 et 4624.

Comme cela est montré par arrachement à la figure 2, des picots 4625 sont disposés dans chacun des conduits 4623A et 4623B, afin de faciliter les échanges thermiques entre le fluide caloporteur circulant dans ces conduits et le boîtier 4621. En variante, ces picots peuvent être remplacés par des ailettes ou d'autres reliefs visant à améliorer le transfert thermique entre le fluide caloporteur et le boîtier 4621. Les picots 4625 ou les ailettes constituent un radiateur au sein du module 462. Pour un bon rendement thermique, ce radiateur est, de préférence, soudé à une plaque support qui supporte les composant du circuit C462.

Selon une autre variante, ces reliefs peuvent être omis.

Les modules 464 et 466 comprennent également des boîtiers unitaires 4641 et 4661 identiques au boîtier 4621.

Lorsque la cellule de commutation 46 est assemblée, les boîtiers unitaires 4621, 4641 et 4661 sont juxtaposés et immobilisés les uns par rapport aux autres par des moyens mécaniques non représentés, de telle sorte que ces boîtiers unitaires 4621, 4641 et 4661 constituent ensemble un boîtier, composite et étanche, 461 de la cellule de commutation 46 et que leurs conduits individuels respectifs sont alignés et raccordés fluidiquement les uns aux autres. Ces conduits constituent alors ensemble respectivement deux canaux 46A et 46B, qui s'étendent sur toute la longueur de la cellule de commutation 46.

Ainsi, les canaux 46A et 46B et les reliefs qu'ils contiennent éventuellement constituent des moyens d'échange thermique répartis sur deux faces opposées du boîtier 461, à savoir sa face inférieure 461A et sa face supérieure 461B dans la représentation des figures 3 et 4.

Un distributeur 60 et un collecteur 70 sont prévus pour, respectivement, alimenter les canaux 46A et 46B en fluide caloporteur et pour évacuer le fluide caloporteur se trouvant dans ces canaux.

Avantageusement, les pièces 60 et 70 sont identiques. Ceci n'est toutefois pas obligatoire.

Le distributeur 60 comprend un corps 61 réalisé dans un matériau thermiquement conducteur, par exemple en métal et, de préférence dans ce cas, en aluminium ou en cuivre, qui est monobloc et qui permet de répartir un écoulement de fluide caloporteur arrivant dans le sens de la flèche F1 à la figure 3, au sein d'une canalisation 82 représentée par un trait d'axe, en deux écoulements F2 et F3 pénétrant respectivement dans les canaux 46A et 46B. Comme cela ressort de la figure 3, le côté du corps 61 orienté vers la cellule de commutation 46 est pourvu de deux orifices de sortie 63A et 63B destinés à être alignés avec les canaux 46A et 46B.

Ceci n'est toutefois pas obligatoire et un distributeur 60 avec un seul orifice de sortie recouvrant les entrées des canaux 46A et 46B est également envisageable.

Le fluide caloporteur introduit dans les canaux 46A et 46B, à partir du distributeur 60, s'écoule suivant la longueur de la cellule de commutation 46, dans le sens des flèches F4 aux figures 3 et 4. De là, le fluide caloporteur sort de la série de boîtiers 4621, 4641 et 4661, par les orifices des canaux 46A et 46B visibles à la figure 3, et pénètre dans le corps 71 du collecteur 70, d'où il ressort sous la forme d'un écoulement F5, au sein d'une canalisation d'évacuation 84, également représentée par un trait d'axe.

Les canalisations 82 et 84 et les canaux 46A et 46B appartiennent à un circuit de circulation du fluide caloporteur, cette circulation étant représentée par les flèches F1 à F5.

Le refroidissement de la cellule de commutation 46 est particulièrement efficace car, d'une part, il a lieu sur les deux faces opposées 461A et 461B du boîtier 461 et, d'autre part, la résistance thermique entre les radiateurs et les circuits C462, C464 et C466 est minimale car les radiateurs sont soudés aux plaques supports.. Les risques d'échauffement des composants des circuits C462, C464 et C466 sont donc limités et il n'est pas nécessaire de prévoir des supports de grandes dimensions. Ce refroidissement bilatéral participe donc à la compacité de la cellule de commutation 46 et, par voie de conséquence, de l'onduleur 4.

La construction modulaire de la cellule de commutation 46 induit des gains en termes de productivité et de maintenance. En effet, en cas de défaut constaté sur l'un des circuits C462, C464, C466, au cours de la fabrication de la cellule 46, il suffit de remplacer le module pour lequel ce défaut a été constaté, sans devoir mettre au rebut l'ensemble de la cellule 46. De même, au cours de la durée de vie de la cellule 46, en cas de dysfonctionnement, il est possible de changer l'un des modules 462, 464 et 466 sans remplacer tous les modules.

Compte tenu du fait que la cellule de commutation 46 ne rayonne pas de chaleur vers les autres éléments de l'onduleur et comme représenté à la figure 4, les cartes électroniques 50 et 52 peuvent être disposées le long d'une des faces de la cellule 46, à savoir la face supérieure 461B du boîtier 461, sans nécessiter d'un refroidissement dédié.

La structure du filtre capacitif 48 ressort plus particulièrement des figures 3 et 4. Ce filtre capacitif 48 comprend, outre les condensateurs 482, deux plaques de contact 484 et 486, disposées respectivement en-dessous et en-dessus des condensateurs 482 dans la représentation des figures 3 et 4..

La plaque de contact inférieure 482 contribue au maintien mécanique de ces condensateurs par rapport au reste de l'onduleur 4. Les plaques de contact 484 et 486 sont reliées mécaniquement entre elles par des organes de montage non représentés, ce qui leur permet d'enserrer les condensateurs 48 pour constituer un sous-ensemble 48 aisément manipulable lors de la fabrication de l'onduleur 4.

En variante, la plaque de contact inférieure 484 peut être remplacée par deux demi-plaques, situées respectivement sous les condensateurs 482 et qui se prolongent par des pattes de fixation sur la plaque de contact 486.

La plaque de contact 486 est une structure multicouche qui comprend un noyau isolant et deux couches conductrices disposées de part et d'autre de ce noyau isolant et permettant de conduire un courant électrique.

La plaque 486 comprend une embase 4862 destinée à être en appui sur et raccordée avec les condensateurs 482, sur leur côté opposé à la plaque 484, ainsi qu'un dossier 4864 qui s'étend perpendiculairement à l'embase 4862 et qui définit six pattes 4866 de raccordement aux bornes d'entrée des différents modules 462, 464 et 466, à savoir deux pattes par module. La plaque supérieure de contact 486 joue ainsi le rôle d'un busbar alimentant la cellule de commutation 46.

Dans une variante non représentée, c'est la plaque 484 qui joue le rôle d'un busbar.

Dans une autre variante non représentée, le filtre capacitif 48 est placé à côté de la cellule de commutation et non pas au-dessus ou au-dessous.

Dans une autre variante, les plaques 484 et 486 peuvent être omises et la connexion électrique entre le filtre capacitif et la cellule de commutation réalisée par un autre moyen.

La plaque de contact 486 définit un dièdre D486 de réception de la cellule de commutation 46 en configuration montée de l'onduleur 4.

Quatre caloducs 92, 94, 96 et 98 font également partie de l'onduleur 4. Ces caloducs, couramment dénommés « heat pipes » en anglais, se présentent chacun sous la forme d'une enceinte hermétique qui renferme un fluide sous forme liquide en équilibre avec sa phase gazeuse, en l'absence d'un autre gaz. A une extrémité d'un caloduc, la plus près d'un élément à refroidir, le liquide chauffe et se vaporise. Le gaz résultant de cette vaporisation se diffuse alors jusqu'à l'autre extrémité du caloduc, où il est refroidi jusqu'à ce qu'il se condense pour redevenir liquide en cédant de l'énergie thermique.

Dans l'exemple, les caloducs 92 à 98 sont réalisés par des enveloppes en cuivre, ou en tout autre métal conducteur de la chaleur, qui renferment de l'ammoniac, ou encore de l'eau, de l'acétone, du méthanol ..., sous forme liquide et gazeuse.

Le caloduc 92 comprend un tronçon 92a collé sur la plaque de contact 484, dans l'exemple sur la face de cette plaque 484 opposée aux condensateurs 482. Le caloduc 92 comprend également une portion d'extrémité 92b collée sur la surface externe 61a du corps 61.

Dans une variante où la plaque de contact 484 est omise, le caloduc est placé en contact thermique direct avec le filtre capacitif 48.

Ainsi, le tronçon 92a du caloduc est en contact thermique avec le filtre capacitif 48 et sa position d'extrémité 92b est en contact thermique avec le distributeur 60.

Au sens de la présente invention, deux pièces sont en contact thermique lorsqu'elles sont disposées de façon à pouvoir échanger de la chaleur entre elles. Plusieurs solutions peuvent être utilisées afin d'assurer une résistance thermique suffisamment faible entre ces deux pièces, dont la soudure, le collage avec des colles thermiquement conductrices, des graisses thermiques, etc.

Ainsi, le produit contenu dans le caloduc 92 se réchauffe au contact de la plaque 484, au sein du tronçon 92a, au point qu'il se vaporise, créant un gradient de température dans le caloduc. Ce gradient de température force la vapeur à se déplacer le long du caloduc jusqu'à atteindre la zone relativement fraîche dans la portion d'extrémité 92b en contact avec le distributeur 60, au point qu'il se condense, libérant ainsi la chaleur extraite de la plaque 484 sur le distributeur 60.

Les caloducs 94, 96 et 98 fonctionnent de la même façon, chacun avec un tronçon 94a, 96a ou 98a collé sur l'une des plaques 484 ou 486 et une portion d'extrémité 94b, 96b ou 98b collée sur la surface externe 61a du corps 61.

Les caloducs 92, 94, 96 et 98 s'étendent en parallèle entre le filtre capacitif 48 et le distributeur 60.

En variante, en fonction de la nature du matériau constitutif des caloducs, ceux-ci peuvent être soudés, d'une part sur les plaques 484 et 486, d'autre part sur le corps 61, voire placés en contact thermique avec ces éléments 484, 486 et 61 par une autre technique, notamment par coincement, brasage, sertissage, collage au moyen d'une colle thermiquement conductrice ou par de la graisse thermique, etc.

Ce montage permet de refroidir efficacement le filtre capacitif 48 et est d'autant plus efficace que les portions d'extrémité 92b, 94b, 96b et 98b sont portées à des températures relativement basses. Tel peut effectivement être le cas car le corps 61 du distributeur 60 est parcouru par le fluide caloporteur non encore réchauffé, puisque ce fluide caloporteur n'a pas encore traversé les canaux 46A et 46B de la cellule de commutation 46.

Puisque le courant traversant le filtre capacitif 48 est divisé par deux comparé à un onduleur traditionnel, l'échauffement de ce filtre du fait de la résistance équivalente de série de toute capacité est divisé par quatre par rapport à ce même onduleur traditionnel. Ainsi, la quantité de chaleur à extraire du filtre capacitif 48 est quatre fois moins importante que pour un onduleur traditionnel et le dispositif proposé permet de maintenir la température des plaques 484 et 486 à moins de 5°C de la température du fluide caloporteur au niveau du distributeur 60.

Afin de pouvoir placer l'onduleur dans un air ambiant jusqu'à 105°C et pour limiter le flux thermique qui devra être évacué par les caloducs, on pourra avantageusement placer l'ensemble formé du filtre capacitif 48 avec ses plaques 484 et 486, ainsi que les caloducs 92 à 98, dans une enveloppe constituée d'un matériau thermiquement isolant et présentant une épaisseur de 1 à 4 mm, par exemple.

Sur les figures 3 et 4, les tronçons 92a et 94a sont représentés en-dessous de la plaque de contact inférieure 484, alors que les tronçons 96a et 98a sont représentés au-dessus de la plaque de contact supérieure 486. En variante, d'autres dispositions sont envisageables.

Les portions d'extrémité 92b et équivalentes peuvent être réparties de part et d'autre du distributeur 60, par exemple avec les portions d'extrémité 92b et 96b sur la portion de la surface 61a visible à la figure 4 et les portions d'extrémité 94b et 98b sur la portion opposée. D'autres répartitions sont également envisageables.

Grâce à la combinaison de caractéristiques mentionnées ci-dessus, l'onduleur 4 de la présente invention peut être particulièrement compact, comme visible à la figure 4, tout en présentant des propriétés électriques compatibles avec son utilisation pour l'alimentation d'un moteur de traction d'un véhicule automobile. Dans l'exemple, l'onduleur 4 peut être alimenté avec une tension V2 comprise entre 300 et 950 V et alimenter chaque phase 62, 64 et 66 du moteur de traction 6 avec deux courants électriques alternatifs dont l'intensité est de 300 A RMS et qui se cumulent pour alimenter chaque phase du moteur avec une intensité de 600 A RMS, alors que l'onduleur 4 présente un volume total inférieur ou égal à 8 litres, de préférence à 6, de préférence encore à 3 litres. En pratique, un tel onduleur peut, grâce à l'invention, présenter un volume de 2 litres.

Ces dimensions seront réduites pour des courants de phase d'intensité RMS inférieure.

En variante, le nombre de caloducs peut être différent de quatre, en restant supérieur ou égal à un, et leur répartition entre les plaques de contact 484 et 486 peut être différente de celle représentée.

Suivant une autre variante, les parties chaudes des caloducs peuvent être en contact directement avec les condensateurs 482.

L'onduleur 4 peut être utilisé pour piloter en courant triphasé une charge électrique autre qu'un moteur de traction, notamment un générateur de courant.

Le nombre de condensateurs 482 du filtre capacitif 48 peut être différent de 2, notamment égal à 1.

Le corps 61 du distributeur 60 peut être réalisé dans un métal autre que l'aluminium, notamment en cuivre, voire dans un matériau non métallique, par exemple un matériau plastique conducteur de la chaleur.

Le mode de réalisation et les variantes envisagés ci-dessus peuvent être combinés entre eux pour générer de nouveaux modes de réalisation de l'invention.

## Revendications

1. Onduleur destiné (4) à être raccordé électriquement à une source (2) de tension continue (V2) pour alimenter une charge électrique (6) en courant triphasé, cet onduleur comprenant :
- une cellule de commutation (46) incluant, pour chaque phase du courant, un circuit (C462, C464, C466) d'alimentation à découpage formé par deux ensembles (E1, E2) d'interrupteurs commandés (4622, 4624), chaque ensemble d'interrupteurs commandés alimentant une borne distincte (4626, 4628, 4646, 4648, 4666, 4668) de la cellule de commutation et la cellule de commutation comprenant un boîtier étanche (461) contenant les circuits d'alimentation à découpage ;
- un filtre capacitif (48) ;
**caractérisé en ce que** :
- le boîtier (461) est pourvu, sur deux faces opposées (461A, 461B), de moyens (46A, 46B, 4625) d'échange thermique avec un fluide caloporteur ;
- un distributeur (60) est monté, en amont du boîtier (461), dans un circuit (82, 84, 46A, 46B) de circulation de fluide caloporteur (F1-F5), pour diriger le fluide caloporteur vers les deux faces opposées du boîtier ;
- le filtre capacitif (48) est refroidi au moyen d'au moins un caloduc (92, 94, 96, 98) ;
- une partie (92b, 94b, 96b, 98b) du caloduc, où se produit la condensation d'un fluide contenu dans le caloduc, est en contact thermique avec le distributeur (60).

2. Onduleur selon la revendication 1, **caractérisé en ce que** le filtre capacitif (48) est refroidi par plusieurs caloducs (92, 94, 96, 98) qui s'étendent en parallèle entre le filtre capacitif (48) et le distributeur (60).

3. Onduleur selon l'une des revendications précédentes, **caractérisé en ce que** la partie de chaque caloduc (92, 94, 96, 98) en contact thermique avec le distributeur (60) est sa portion d'extrémité (92b, 94b, 96b, 98b) opposée au filtre capacitif (48).

4. Onduleur selon l'une des revendications précédentes, **caractérisé en ce que** la partie (92b, 94b, 96b, 98b) de chaque caloduc (92, 94, 96, 98) en contact thermique avec le distributeur (60) est collée ou soudée sur une surface externe (61a) du distributeur.

5. Onduleur selon l'une des revendications précédentes, **caractérisé en ce que** la cellule de commutation (46) est divisée en trois modules (462, 464, 466) qui comprennent chacun :
- deux bornes d'entrée ;
- deux bornes de sortie (4626, 4628, 4646, 4648, 4666, 4668) ;
- deux ensembles (E1, E2) d'interrupteurs (4622, 4624), montés en parallèle entre les deux bornes d'entrée et raccordés chacun à une borne de sortie ; et
- une partie (4621, 4641, 4661) du boîtier qui inclut les deux ensembles d'interrupteurs.

6. Onduleur selon l'une des revendications précédentes, **caractérisé en ce que** le boîtier (461) définit un canal (46A, 46B) de circulation de fluide caloporteur sur chacune de ses faces opposées (461A, 461B).

7. Onduleur selon les revendications 5 et 6, **caractérisé en ce que** chaque partie (4621, 4641, 4661) du boîtier (461) définit une partie (4623A, 4623B) de chacun des canaux (46A, 46B) de circulation de fluide caloporteur et ces parties de conduits sont alignées et en communication fluidique lorsque la cellule de commutation est constituée par l'assemblage des trois modules (462, 464, 466).

8. Onduleur selon l'une des revendications précédentes, **caractérisé en ce que** le filtre capacitif (48) comprend au moins un condensateur (482) relié à la cellule de commutation (46) au moyen d'un busbar, **en ce qu'**au moins un caloduc (92, 94, 96, 98) est en contact thermique directement avec le filtre capacitif ou indirectement, c'est-à-dire avec une plaque ou un élément du busbar, lui-même en contact avec le filtre capacitif et **en ce que** ce caloduc est également en contact avec le distributeur (60).

9. Onduleur selon l'une des revendications précédentes, **caractérisé en ce que** le filtre capacitif (48) a une capacité supportant une tension d'alimentation entre 300 V et 950 V, **en ce que** la cellule de commutation (46) est apte à alimenter chaque phase (62, 64, 66) de la charge électrique (6) avec deux courants électriques alternatifs dont l'intensité est comprise entre 100 et 500 A RMS, **en ce que** l'onduleur délivre des courants de phase cumulés de 600 A RMS et **en ce que** le volume total de l'onduleur (4) est inférieur ou égal à 8 litres, de préférence à 6 litres, de préférence encore à 3 litres.

10. Véhicule automobile (V) comprenant une batterie d'accumulateurs (2), un moteur électrique de traction (6) et un onduleur (4) d'alimentation du moteur de traction en courant triphasé, à partir d'un courant continu délivré par la batterie d'accumulateurs, **caractérisé en ce que** l'onduleur (4) est selon l'une des revendications précédentes.

## Patentansprüche

1. Wechselrichter (4), der vorgesehen ist, elektrisch an eine Quelle (2) einer Gleichspannung (V2) angeschlossen zu werden, um eine elektrische Last (6) mit einem dreiphasigen Strom zu versorgen, wobei dieser Wechselrichter umfasst:
- eine Schaltzelle (46), die für jede Stromphase eine Zerhackerversorgungsschaltung (C462, C464, C466) einschließt, die von zwei gesteuerten Schalteranordnungen (E1, E2; 4622, 4624) gebildet wird, wobei jede gesteuerte Schalteranordnung einen unterschiedlichen Anschluss (4626, 4628, 4646, 4648, 4666, 4668) der Schaltzelle speist und die Schaltzelle ein dichtes Gehäuse (461) umfasst, das die Zerhackerversorgungsschaltungen enthält;
- einen kapazitiven Filter (48);
**dadurch gekennzeichnet, dass**:
- das Gehäuse (461) an zwei entgegengesetzten Seiten (461A, 461B) mit Mitteln (46A, 46B, 4625) für einen Wärmeaustausch mit einem Wärmeträgerfluid versehen ist;
- ein Verteilerelement (60) stromaufwärts zum Gehäuse (461) in einem Zirkulationskreis (82, 84, 46A, 46B) für ein Wärmeträgerfluid (F1 - F5) vorgesehen ist, um das Wärmeträgerfluid zu den zwei entgegengesetzten Seiten des Gehäuses zu leiten;
- der kapazitive Filter (48) mittels mindestens eines Wärmerohrs (92, 94, 96, 98) gekühlt wird;
- ein Teil (92b, 94b, 96b, 98b) des Wärmerohrs, in dem die Kondensation eines in dem Wärmerohr enthaltenen Fluid erzeugt wird, in Wärmekontakt mit dem Verteilerelement (60) ist.

2. Wechselrichter nach Anspruch 1, **dadurch gekennzeichnet, dass** der kapazitive Filter (48) durch mehrere Wärmerohre (92, 94, 96, 98), die sich parallel zwischen dem kapazitiven Filter (48) und dem Verteilerelement (60) erstrecken, gekühlt wird.

3. Wechselrichter nach einem der vorhergehenden Ansprüche, **dadurch gekennzeichnet, dass** der Teil jedes Wärmerohrs (92, 94, 96, 98), der in Wärmekontakt mit dem Verteilerelement (60) ist, sein Endbereich (92b, 94b, 96b, 98b) entgegengesetzt zum kapazitiven Filter (48) ist.

4. Wechselrichter nach einem der vorhergehenden Ansprüche, **dadurch gekennzeichnet, dass** der Teil (92b, 94b, 96b, 98b) jedes Wärmerohrs (92, 94, 96, 98) in Wärmekontakt mit dem Verteilerelement (6) an die Außenfläche (61a) des Verteilerelements geklebt oder geschweißt ist.

5. Wechselrichter nach einem der vorhergehenden Ansprüche, **dadurch gekennzeichnet, dass** die Schaltzelle (46) in drei Module (462, 464, 466) aufgeteilt ist, jeweils umfassen:
- zwei Eingangsanschlüsse;
- zwei Ausgangsanschlüsse (4626, 4628, 4646, 4648, 4666, 4668);
- zwei Schalteranordnungen (E1, E2; 4622, 4624), die parallel zwischen den zwei Eingangsanschlüssen angeordnet sind und jeweils mit einem Ausgangsanschlüssen verbunden sind; und
- einen Teil (4621, 4641, 4661) des Gehäuses, der die zwei Schalteranordnungen einschließt.

6. Wechselrichter nach einem der vorhergehenden Ansprüche, **dadurch gekennzeichnet, dass** das Gehäuse (461) einen Zirkulationskanal (46A, 46B) für ein Wärmeträgerfluid an jedem seiner entgegengesetzten Seiten (461A, 461B) definiert.

7. Wechselrichter nach den Ansprüchen 5 und 6, **dadurch gekennzeichnet, dass** jeder Teil (4621, 4641, 4661) des Gehäuses (461) einen Teil (4623A, 4623B) jedes der Zirkulationskanäle (46A, 46B) für ein Wärmeträgerfluid definiert und diese Kanalteile ausgerichtet und in Fluidverbindung sind, wenn die Schaltzelle von der Gruppe der drei Module (462, 464, 466) gebildet wird.

8. Wechselrichter nach einem der vorhergehenden Ansprüche, **dadurch gekennzeichnet, dass** der kapazitive Filter (48) mindestens einen Kondensator (482) umfasst, der an die Schaltzelle (46) mittels einer Sammelschiene angeschlossen ist, dass mindestens ein Wärmerohr (92, 94, 96, 98) in Wärmekontakt direkt mit dem kapazitiven Filter oder indirekt, d. h. mit einer Platte oder einem Element der Sammelschiene, die selbst in Kontakt mit dem kapazitiven Filter sind, ist und dass dieses Wärmerohr gleichfalls in Kontakt mit dem Verteilerelement (60) ist.

9. Wechselrichter nach einem der vorhergehenden Ansprüche, **dadurch gekennzeichnet, dass** der kapazitive Filter (48) eine Kapazität aufweist, die eine Versorgungsspannung zwischen 300 V und 950 V erträgt, dass die Schaltzelle (46) in der Lage ist, jede Phase (62, 64, 66) der elektrischen Last (6) mit zwei elektrischen Wechselströmen zu versorgen, deren Stärke zwischen 100 und 500 A als Effektivwert liegt, dass der Wechselrichter kumulierte Phasenströme von 600 A als Effektivwert liefert und dass das Gesamtvolumen des Wechselrichters (4) kleiner als oder gleich 8 Liter, vorzugsweise 6 Liter, noch bevorzugte 3 Liter beträgt.

10. Kraftfahrzeug (V), das eine Akkumulatorbatterie (2), einen elektrischen Antriebsmotor (6) und einen Wechselrichter (4) zum Speisen des Zugmotors mit dreiphasigem Strom aus einem von der Akkumulatorbatterie gelieferten Gleichstrom umfasst, **dadurch gekennzeichnet, dass** der Wechselrichter (4) nach einem der vorhergehenden Ansprüche ausgebildet ist.

## Claims

1. An inverter (4) intended to be electrically connected to a DC voltage (V2) source (2) to supply an electric charge (6) with three-phase current, this inverter including:
- a switching cell (46) that in turn includes, for each phase of the current (C462, C464, C466), a switching mode power supply circuit formed by two sets (E1, E2) of controlled switches (4622, 4624), each set of controlled switches supplying a separate terminal (4626, 4628, 4646, 4648, 4666, 4668) of the switching cell, while this switching cell includes a sealed housing (461) containing the switching mode power supply circuits;
- a capacitive filter (48);
**characterized in that**:
- the housing (461) is provided, on two opposite surfaces (461A, 461B), with heat exchange means (46A, 46B, 4625) with a heat transfer fluid;
- a distributor (60) is mounted, upstream from the housing (461), in a heat transfer fluid circulation circuit (82, 84, 46A, 46B), to steer the heat transfer fluid (F1-F5) toward the two opposite surfaces of the housing;
- the capacitive filter (48) is cooled using at least one heat pipe (92, 94, 96, 98);
- part (92b, 94b, 96b, 98b) of this heat pipe, where the condensation of a fluid contained in the heat pipe occurs, is in thermal contact with the distributor (60).

2. The inverter according to claim 1, **characterized in that** the capacitive filter (48) is cooled by several heat pumps (92, 94, 96, 98) that extend in parallel between the capacitive filter (48) and the distributor (60).

3. The inverter according to one of the preceding claims, **characterized in that** the part of each heat pump (92, 94, 96, 98) in thermal contact with the distributor (60) is its end portion (92b, 94b, 96b, 98b) opposite the capacitive filter (48).

4. The inverter according to one of the preceding claims, **characterized in that** the part (92b, 94b, 96b, 98b) of each heat pump (92, 94, 96, 98) in thermal contact with the distributor (60) is glued or welded on an outer surface (61a) of the distributor.

5. The inverter according to one of the preceding claims, **characterized in that** the switching cell (46) is divided into three modules (462, 464, 466) that each include:
- two input terminals;
- two output terminals (4626, 4628, 4646, 4648, 4666, 4668);
- two sets (E1, E2) of switches (4622, 4624), mounted in parallel between the two input terminals and each connected to an output terminal; and
- a part (4621, 4641, 4661) of the housing that includes the two sets of switches.

6. The inverter according to one of the preceding claims, **characterized in that** the housing (461) defines a heat transfer fluid circulation channel (46A, 46B) on each of its opposite surfaces (461A, 461B).

7. The inverter according to claim 5 and 6, **characterized in that** each part (4621, 4641, 4661) of the housing (461) defines a part (4623A, 4623B) of each of the heat transfer fluid circulation channels (46A, 46B) and these pipe parts are aligned and in fluid communication when the switching cell is made up of the assembly of the three modules (462, 464, 466).

8. The inverter according to one of the preceding claims, **characterized in that** the capacitive filter (48) includes at least one capacitor (482) connected to the switching cell (46) via a busbar, at least one heat pipe (92, 94, 96, 98) is in thermal contact directly with the capacitive filter or indirectly, i.e., in contact with a plate or an element of the busbar, in turn in contact with the capacitive filter, and this heat pipe is also in contact with the distributor (60).

9. The inverter according to one of the preceding claims, **characterized in that** the capacitive filter (48) has a capacity supporting a supply voltage between 300 V and 950 V, **in that** the switching cell (46) is able to supply each phase (62, 64, 66) of the electric charge (6) with two AC electric currents, **in that** the intensity of which is comprised between 100 and 500 A RMS, **in that** the inverter delivers cumulative line currents of 600 A RMS and **in that** the total volume of the inverter (4) is less than or equal to 8 liters, preferably 6 liters, still more preferably 3 liters.

10. A motor vehicle (V) including a storage battery (2), an electric traction motor (6) and an inverter (4) for supplying this traction motor with three-phase current, from a DC current delivered by the storage battery, **characterized in that** the inverter (4) is according to one of the preceding claims.
